(19) Europäisches Patentamt / European Patent Office / Office européen des brevets

(11) **EP 4 297 035 A1**

(12) **EUROPEAN PATENT APPLICATION**

(43) Date of publication:
**27.12.2023 Bulletin 2023/52**

(21) Application number: **22179955.4**

(22) Date of filing: **20.06.2022**

(51) International Patent Classification (IPC):
**G11C 29/00** (2006.01)   **G01R 33/12** (2006.01)

(52) Cooperative Patent Classification (CPC):
**G11C 29/006; G01R 33/032; G01R 33/1207;**
G11C 11/161; G11C 2029/1206

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Qnami AG**
**4132 Muttenz (CH)**

(72) Inventor: **Rickhaus, Peter**
**4054 Basel (CH)**

(74) Representative: **P&TS SA (AG, Ltd.)**
**Avenue J.-J. Rousseau 4**
**P.O. Box 2848**
**2001 Neuchâtel (CH)**

(54) **METHOD FOR DETERMINING SWITCHING OF NANOMAGNETS**

(57) The invention concerns a method for characterizing a magnetic device including a plurality of binary nanomagnets, which may be arranged in an array, comprising (i) applying a saturation magnetic field ($\mu_0 H_{sat}$) having a first direction to a plurality of binary nanomagnets to induce a first magnetic orientation in the plurality of nanomagnets, (ii) applying a second magnetic field ($\mu_0 H_c$) having a second direction, which is different to the first direction, to the plurality of nanomagnets, repeating steps (i) to (ii), determining a first fraction or percentage ($\alpha$) of nanomagnets which switched orientation in step (ii) and a second fraction or percentage ($\alpha_1$) of nanomagnets which switched orientation in the repeated step (ii), determining a statistical double-switching percentage $\beta_{ideal}$ based on the determined first fraction or percentage $\alpha$ and the determined second fraction or percentage $\alpha_1$ of nanomagnets which switched orientation, and determining the effective double-switching fraction or percentage ($\beta$) of individual nanomagnets which have switched orientation in step (ii) as well as in the repeated step (ii), wherein a statement about the quality of the plurality of nanomagnets is made based on the comparison between the determined statistical double-switching percentage ($\beta_{ideal}$) and the determined effective double-switching percentage ($\beta$) of the plurality of nanomagnets.

Fig. 1A

EP 4 297 035 A1

## Description

## Technical domain

The present invention concerns a method for investigating the quality of a plurality of binary nanomagnets, for example in magnetic random access memory (MRAM).

## State of the Art

Magnetic random access memory (MRAM) is a non-volatile memory technology with excellent growth perspectives. It is currently being manufactured by semiconductor foundries and has the potential to replace memories in consumer electronics.

The quality control of MRAM wafers is critical. State of the art metrology methods either characterize the blanket quality, e.g. by the magneto-optical Kerr effect (MOKE) microscopy or electrically test individual MRAM bits, or nanomagnets, at the end of the fabrication process. For the latter electrical connections to the MRAM wafer, respectively to the magnetic nanopillars of the MRAM wafer have to be established.

However, to date no satisfactory metrology method exists, which is capable of determining the quality of an MRAM wafer after the crucial etching step in the fabrication process. Distinguishing good and bad wafers at this stage of fabrication would be cost effective, as wafers which do not pass a quality test can be sorted out and without the need to be further processed. This saves a significant amount of fabrication time, thus allowing foundries for higher overall throughput, and is significantly more cost-effective.

It is an object of this invention to overcome the shortcomings and limitations of the state of the art.

## Short disclosure of the invention

It is an aim of the present invention to provide a method for determining the quality of MRAM wafers and/or other arrangements nanomagnets with binary switching behaviour.

According to the invention, one or more of these aims are attained by the object of the attached claims, and especially by the independent claim.

In particular, one or more aims are attained by a method for characterizing a magnetic device including a plurality of binary nanomagnets.

The method is suitable for determining the switching behaviour of individual binary nanomagnets comprised in the magnetic device.

The term nanomagnet as used herein means a magnet having a typical diameter of 10nm to 10$\mu$m, or of 20nm to 5$\mu$m and a height of sub-nanometre, or "atomically flat", to 10 $\mu$m, preferably between 1nm and 50nm.

Nanomagnets may for example be made of one or more ferromagnetic metals, such as iron, cobalt or nickel, and may comprise further transitional metals, such as titanium, vanadium, chromium, or manganese.

The plurality of binary nanomagnets of the magnetic device may be arranged in an array. To this end, the nanomagnets may be arranged on or embedded in a carrier element. Nanomagnets may also be embedded in MRAM pillars, containing other materials and multiple magnetic layers.

Today, storage density of nanomagnetic arrays defined by the pitch size may be as low as 100nm. However, there is room for improvement and with SNVM a pitch size of as low as 10nm can be measured. Therefore, when SNVM is used to measure switching behaviour, nanomagnetic arrays with a density of as high as 1 nanomagnet / (10nm*10nm) can be examined.

The storage density of the plurality of nanomagnets ranges examined by this method may for example range from 1 nanomagnets per (200nm * 200nm) to 1 nanomagnet per (100nm * 100nm), or from 1 nanomagnets per (100nm * 100nm) to 1 nanomagnet per (100nm * 100nm).

A magnetic device may comprise one or more of the carrier elements with the plurality of nanomagnets. A magnetic device may be a device for storing binary information, for example a MRAM wafer.

When arranged in an MRAM wafer, the nanomagnets are also referred to as nanopillars due to their cylindrical shape. Nanopillars in a MRAM wafer ranging typically have diameters from 10nm to 1$\mu$m. The method is not restricted to an MRAM geometry but can be applied to any nanomagnets with a binary switching behaviour. In particular, the method is useful for any storage device comprising nanomagnets for encoding binary information in the magnetization direction of individual nanomagnets.

Preferably the magnetic stray field should differ by a value from 1 $\mu$T, to about 1mT, or about > 10 $\mu$T to 100 $\mu$T at the surface of an array of nanomagnets, such that the magnetic stray field is clearly distinguishable between the two binary states of the individual nanomagnets.

The nanopillars may be embedded in a MRAM wafer. If the nanopillars are embedded, the distance of the magnetic free layer to the surface should not be larger than the MRAM disc diameter and disc spacing.

In SNVM, the spatial resolution is defined by the distance between the measured surface of the nanomagnet and NV$^-$ centre of the sensing probe, wherein a decrease in distance results in an increase in spatial resolution.

The plurality of nanomagnets may also be arranged in devices having a different geometry.

The method of this invention comprises

(i) applying a saturation magnetic field $\mu_0 H_{sat}$ having a first direction to a plurality of binary nanomagnets to induce a first magnetic orientation in the plurality of nanomagnets,

(ii) applying a second magnetic field $\mu_0 H_c$ having a second direction, which is different to the first direction, to the plurality of nanomagnets,

(iii) repeating steps (i) to (ii),

(iv) determining a first fraction or percentage $\alpha$ of nanomagnets which switched orientation in step (ii) and a second fraction or percentage $\alpha_1$ of nanomagnets which switched orientation in the repeated step (ii),

(v) determining a statistical double-switching percentage $\beta_{ideal}$ based on the determined first fraction or percentage $\alpha$ and the determined second fraction or percentage $\alpha_1$ of nanomagnets which switched orientation;

(vi) determining the effective double-switching fraction or percentage $\beta$ of individual nanomagnets which have switched orientation in step (ii) as well as in the repeated step (ii).

While step (i) is performed first and step (ii) after step (i), the order of the other steps is less important, as long as they logically follow the workflow.

Steps of determining the first $\alpha$ and second $\alpha_1$ fractions or percentages of switched nanomagnets may be performed after steps (i) and steps (ii) based on measurements made on the plurality of nanomagnets, or it may be performed later based the data and/or images obtained from such measurements.

The second direction of the second magnetic field $\mu_0 H_c$ is preferably directly opposed to the first direction of the saturation magnetic field $\mu_0 H_{sat}$.

The statistical double-switching percentage $\beta_{ideal}$ may be calculated as follows:

$$\beta_{ideal\ n+1} = \alpha * \alpha_1$$

The strength of the opposite magnetic field $\mu_0 H_c$ applied in step (ii) is preferably inferior to the magnetic field strength required for saturation of the plurality of binary nanomagnets. The strength of the opposite magnetic field $\mu_0 H_c$ applied in step (ii) is therefore preferably less than the saturation magnetic field $\mu_0 H_{sat}$ applied in step (i)

For step (i) the magnetic field strength is chosen such that a saturation stage is reached for the plurality of binary nanomagnets. The field strength typically depends on the magnetic material used, additional magnetic layers, such as the reference layer, and the thickness of the magnetic material. The field strength is also influenced by the diameter of the nanomagnets. As a result, the saturation field strength varies depending on the plurality of nanomagnets, respectively the array of nanomagnets. A typical field value for a saturation field may for example be a value in the range of 100 mT to 1 T.

The saturation magnetic field $\mu_0 H_{sat}$ t is applied to initialize all binary nanomagnets in one state, having a first magnetic orientation.

The application of the opposite magnetic field $\mu_0 H_c$ having an opposite direction to the saturation magnetic field $\mu_0 H_{sat}$, induces switching of the magnetic orientation a certain percentage of the binary nanomagnets. The strength of the opposite magnetic field $\mu_0 H_c$ is within the thermally broadened coercive field range of the nanomagnets, to provide a finite probability that at least one and at most all except for one nanomagnets switches its magnetization direction.

When the cycle of applying the saturation magnetic field $\mu_0 H_{sat}$ t of the first orientation and subsequently applying an opposite magnetic field $\mu_0 H_c$ having the opposite direction is repeated, a second percentage $\alpha_1$ of nanomagnets will again switch its orientation. When multiplying the percentage $\alpha$ of switching nanomagnets of step (ii) in the first cycle with the percentage $\alpha_1$ of switching nanomagnets in step (ii) of the repeat cycle, a statistical value is obtained, which indicated the statistical probability of double-switching $\beta_{ideal}$ of the plurality of nanomagnets, which would be expected thermally.

To determine whether the percentage of nanomagnets which effectively switched in the first step (ii) as well as in the repeat step (ii), i.e. the effective double-switch percentage $\beta$, the identity of the switching nanomagnets may be determined after the first step (ii) as well as after the repeat step (ii). The identity may also be determined at a later stage based on data obtained from the measurements performed or images taken after each step (i) and step (ii). Double-switching of an individual nanomagnet can then be determined.

In other words, it is verified for each of the individual nanomagnets which was used to determine $\alpha$ and $\alpha_1$ whether any of these nanomagnets switched twice. The percentage of those nanomagnets which switched twice is then calculated as $\beta$.

The identification of an individual nanomagnet may be based on said nanomagnet's local information, such as its position. This local information of individual nanomagnets may be used to establish a map.

The identification of individual nanomagnets of the plurality of nanomagnets, which may be arranged in an array, is preferably be based on the local information of the individual nanomagnets, for example the position of a nanopillar in or on a MRAM wafer.

Preferably, the determination of the orientation and the position of the nanomagnets are performed in a magnetometry scanning step. Ideally, the scanning step is performed after step (ii), the application of the opposite magnetic field $\mu_0 H_c$. The scan should be performed over a statistically relevant amount of nanomagnets, which may be arranged in a wafer or a device. The scan should be configured to identify the binary status of orientation of each measured nanomagnet. In order to establish the uniform binary status of the nanomagnets following step (i), the application of the saturation magnetic field $\mu_0 H_{sat}$, a magnetometry scan may also be performed following this step.

Nanomagnets of binary nanomagnetic arrays are typically arranged at distances ranging from 250nm to 50nm from one another. Ideally, the scanning magnetometer should therefore be capable of achieving a maximum spatial resolution of less than 100nm, or less than 50 nm or less than 10nm.

A scanning and/or mapping of the plurality of nanopillars may be performed following each step (ii) to determine the orientation and the local information, such as the position of the individual binary nanopillars.

The spatial resolution and/or magnetic field sensitivity of commonly used magnetometry techniques methods known in the art, such as magnetic force microscopy (MFM) or Magneto-Optical Kerr Effect (MOKE) microscopy, is insufficient to reliably detect the differences in magnetic orientation of nanomagnets in MRAM devices.

Magnetometry mapping is therefore preferably be conducted using a scanning nitrogen vacancy magnetometry (SNVM). SNVM is particularly suited for this method, as it provides excellent magnetic field sensitivity and spatial resolution. The technology has advanced greatly in recent years and commercial SNVM microscopes are available today.

To achieve the required spatial resolution SNVM systems should comprise a solid-state lattice sensor probe, preferably made of a monocrystalline diamond, with a single colour centre. The colour centre is preferably a nitrogen vacancy point defect in the diamond lattice. The colour centre nitrogen vacancy defect should be located no more than 100 nm, no more than 50 nm, or no more than 20 nm, ideally no more than 10 nm from the sensing surface of the sensing solid state lattice probe.

However, SNVM systems have never been used to measure switching behaviour of binary nanomagnets. In particular, SNVM systems have never been used to detect switching in binary nanomagnetic arrays.

Moreover, SNVM is suitable for determining switching behaviour at ambient conditions. The system and samples therefore do not need to be cooled to and maintained at low temperature to allow for measurements under cryogenic conditions, as required by other methods, for example superconducting quantum interference device (SQUID) on tip magnetometry.

By comparing the determined statistical double-switching percentage $\beta_{ideal}$ and the determined effective double-switching percentage $\beta$ of the plurality of nanomagnets, a statement is made about the quality of the plurality of nanomagnets.

The statement may be made on the assumption that the quality of the plurality of nanomagnets, which may be arranged in an array, decreases with the increase of difference between the determined statistical double-switching percentage $\beta_{ideal}$ and the determined effective double-switching percentage $\beta$.

Discrepancies between the determined statistical double-switching percentage $\beta_{ideal}$ and the determined effective double-switching percentage $\beta$ may for example result from physical or geometrical defects of the nanomagnets or deviations in the critical dimensions.

The quality may decrease with the increase of difference between the determined statistical double-switching percentage $\beta_{ideal}$ and the determined effective double-switching percentage $\beta$. The quality may for example decrease proportionally with the increase of difference between the determined statistical double-switching percentage $\beta_{ideal}$ and the determined effective double-switching percentage $\beta$.

The cycle of applying the saturation magnetic field $\mu_0 H_{sat}$ and subsequently the opposite magnetic field $\mu_0 H_c$ may be repeated more than once.

For multiple repeats, each repeat n a percentage $\alpha_n$ of nanomagnets which switched orientation in repeat n of step (ii) is determined, wherein nanomagnets which switched orientation in repeat n of step (ii) are identified, wherein the statistical probability of multiple switching $\beta_{ideal\ n+1}$ of the nanomagnets, which switched orientation in step (ii) and in all the subsequent repeats n of step (ii) is determined, wherein the effective multiple-switching percentage $\beta_{n+1}$ is determined cumulatively for all repeats, and wherein a statement about the quality of the plurality of nanomagnets is made based on the comparison between the statistical probability of multiple switching $\beta_{ideal\ n+1}$ and the effective multiple switching percentage $\beta_{n+1}$ of the plurality of nanomagnets.

When more than one repeat of the switching cycle, i.e. step (i) and step (ii) of the method, are performed, the statistical probability of multiple switching $\beta_{ideal\ n+1}$ may be calculated as a percentage according to the formula

$$\beta_{ideal\ n+1} = \alpha * \alpha_1 * \ldots.* \alpha_n ,$$

wherein n is the number of repeats.

The method provides the distinct advantage, that it can be performed without the need for electrically contacting the nanomagnets or the device comprising the nanomagnets.

It is also possible to determine, based on the magnetic history of the plurality of nanomagnets in combination with the local information of individual nanomagnets, which switched orientation after step (ii), preferably the first step (ii), the likelihood of a switching of nanomagnets with a defined local information in a subsequent repeat of step (ii).

With respect to what is known in the art, the invention provides the advantage that it is a non-invasive technique to identify the status of a plurality of nanomagnets, in particular nanomagnets arranged in binary nanomagnetic arrays, such as binary information storage devices, requiring no electrical contact during measurement. The impact on the plurality of nanomagnets, respectively the device, is therefore minimal, such that the introduction of defects is avoided.

## Short description of the drawings

Exemplar embodiments of the invention are disclosed in the description and illustrated by the drawings in which:

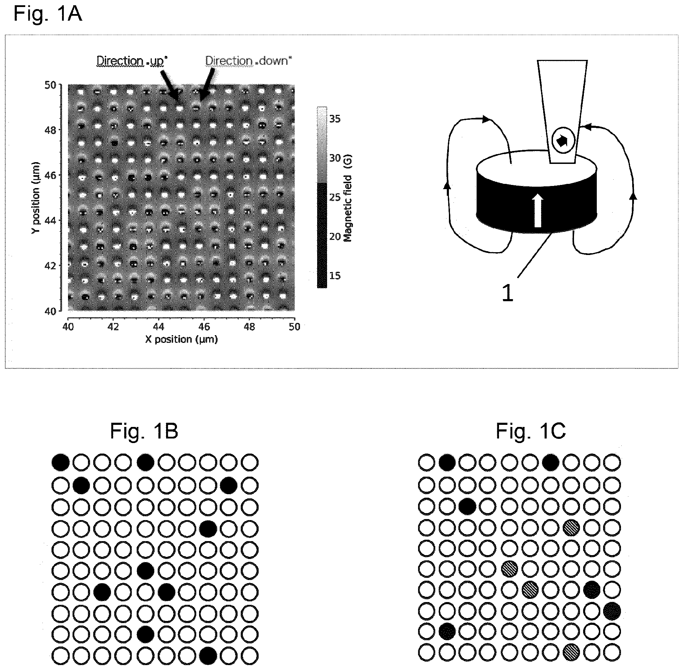

Figure 1A is an optically detected magnetic resonance scan of a portion of a MRAM wafer obtained with the SNVM system used in this study, the orientation of the spin defect in the sensor probe is indicated by an arrow; the orientation of magnetization of the cylindrical binary nanomagnet is also indicated with an arrow. The circular lines schematically represent the magnetic field lines.

Figures 1B and 1C schematically depict the same portion of a microarray after a switching cycle of applying a first saturated and subsequently a second alternate magnetic field; Nanomagnets which switched once are shown in dark grey, nanomagnets which switched twice, once in each cycle, are shown in white, medium grey nanomagnets did not switch;

Figure 1B shows nanomagnets after a first switching cycle

Figure 1C shows nanomagnets after a repeat switching cycle;

Figures 2A, 2B and 2C, schematically depict the flow of subsequent the switching cycles and show the images obtained for each cycle after the application of the second magnetic field for inducing switching behaviour of the nanomagnets;

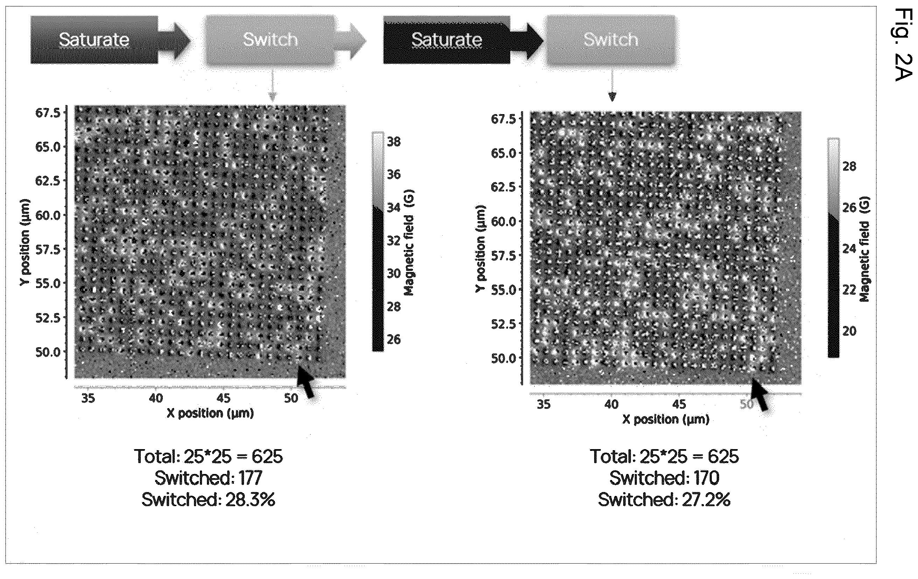

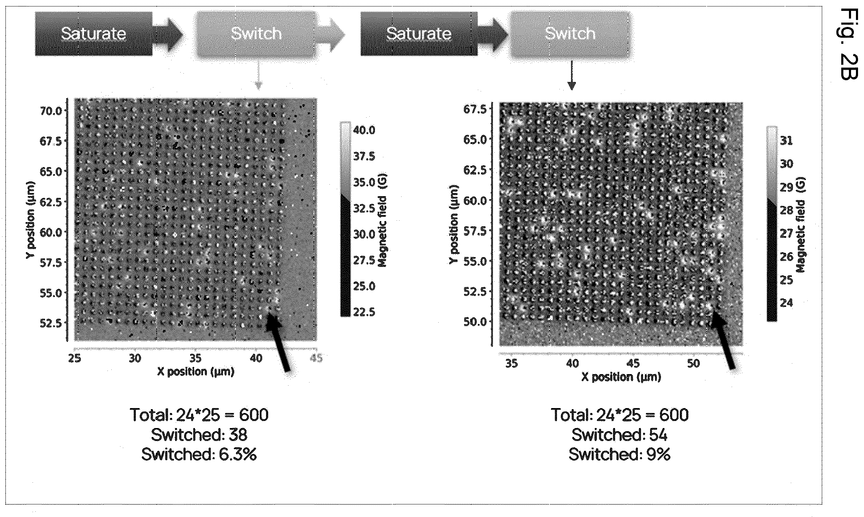

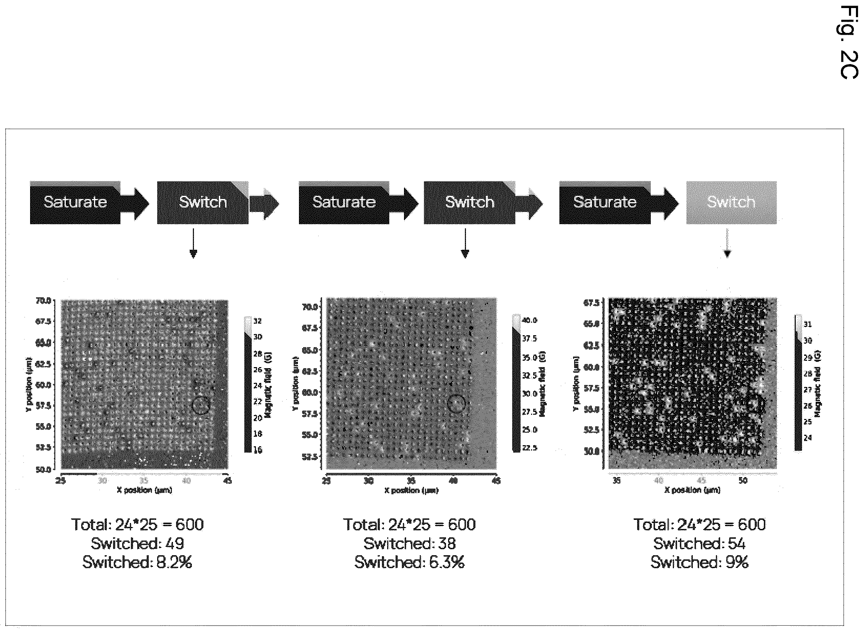

Figures 2A and 2B depict two examples of two consecutive switching cycles, and

Figure 2B depicts three consecutive switching cycles;

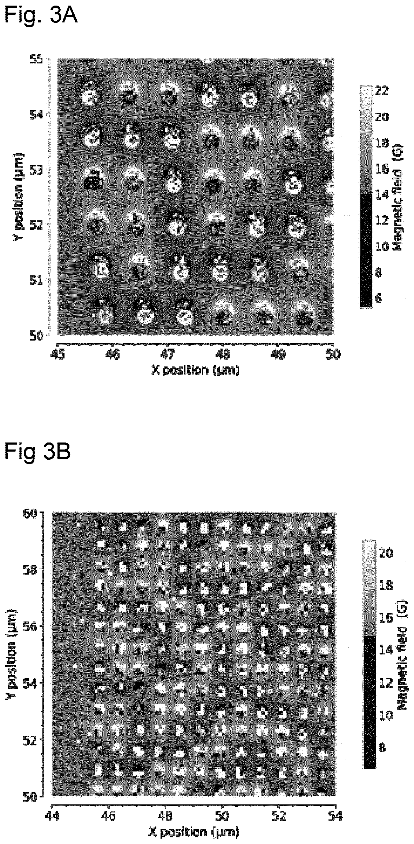

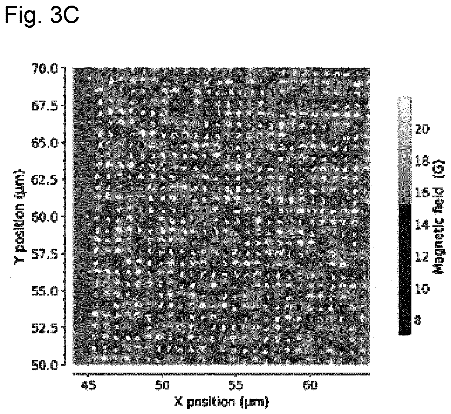

Figures 3A, 3B and 3C are images obtained with the SNVM system used in this study of a portion of a MRAM wafer in Full-B mode, the sample magnetic field ranges of the sweep ranged from 6G or 8G to 20G or 22G, corresponding to a range of 0.6mT or 0.8mT to 20mT or 22mT with respect to the bias magnetic field applied along the NV$^-$ centre axis in the range of 15G (0.15 mT);

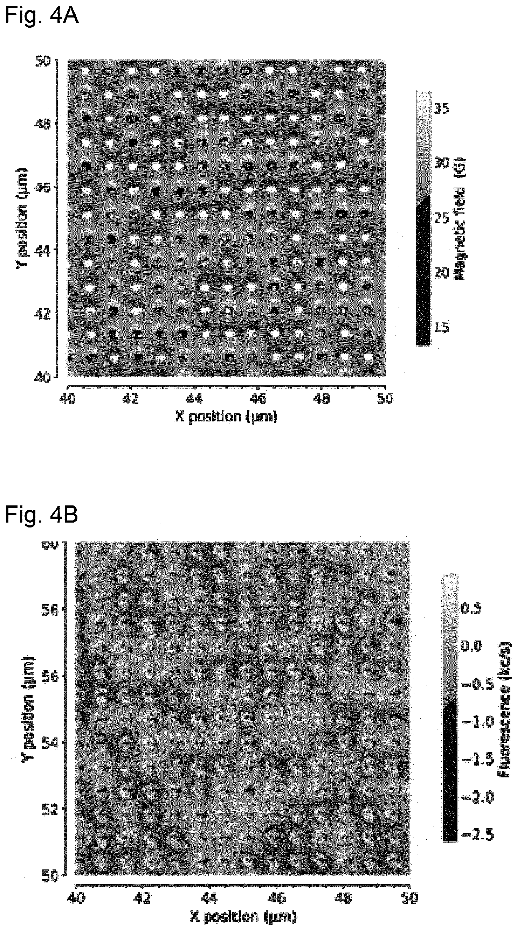

Figure 4A is an image obtained with the SNVM system used in this study of a portion of a MRAM wafer in Full-B mode over a measurement time of 3 hours; the magnetic field $B_{NV}$ of the sweep ranged from 1.5mT to 3.5mT;

Figure 4B is an image obtained with the SNVM system used in this study of a portion of a MRAM wafer in dual iso-B mode corresponding to a magnetic field component of $B_{NV}$=0.2m; the grey scale indicates the fluorescence output signal in kilo counts per second (kc/s);

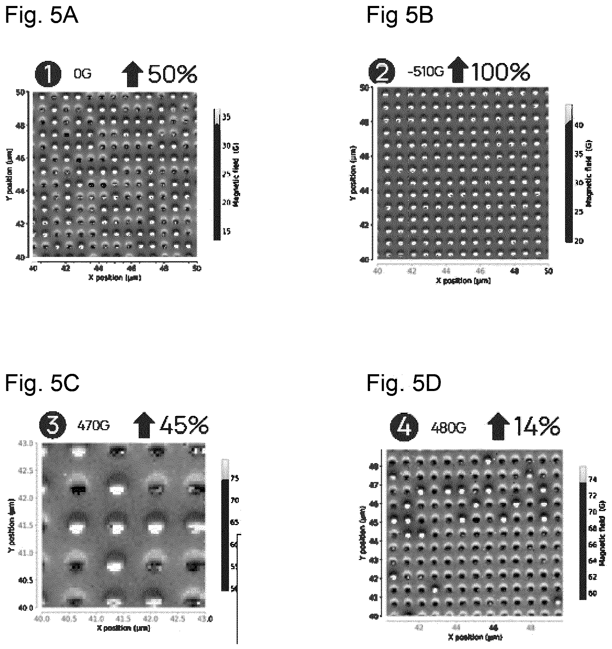

Figures 5A to 5E are images of magnetic sweeps detected with the SNVM system used in this study of a portion of a MRAM wafer; the sweeps were performed to the saturation field, and then back to a different field $\mu_0 H_c$, where a certain proportion of the nanomagnets switch. Measurements were taken around $B_{NV}$=0;

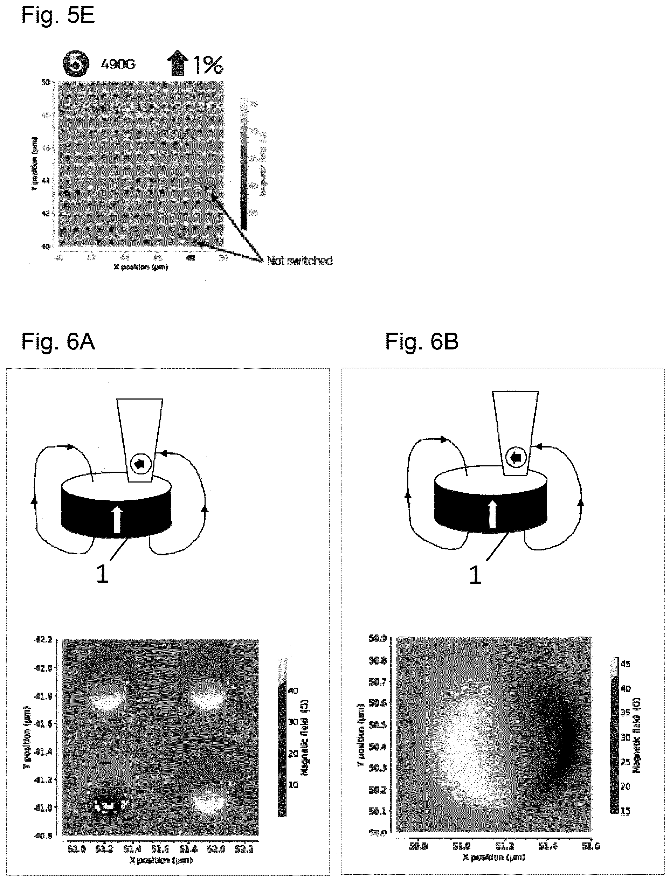

Figures 6A to 6D show images of the orientation of the magnetized nanomagnet obtained with the SNVFM system used in this study,

In Figure 6A orientation of spin of the NV center of the sensing probe was at an angle upward of 45° with respect to the measured surface of the nanomagnet;

In Figure 6B the orientation of spin of the NV center of the sensing probe was in plane with the measured surface of the nanomagnet;

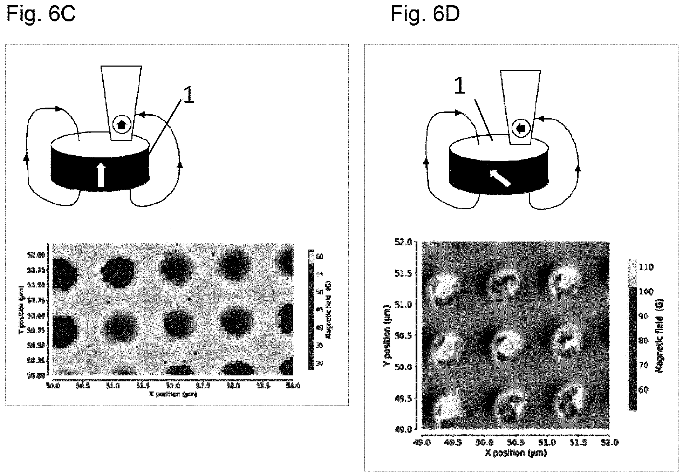

In Figure 6C orientation of spin of the NV center of the sensing probe was off plane with the measured surface of the nanomagnet;

In Figure 6D the magnetic field applied to the nanomagnet was tilted, wherein the orientation of spin of the NV center of the sensing probe was in plane with the measured surface of the nanomagnet;

## Examples of embodiments of the present invention

The Figures show results of examples of experiments performed according to the method of this invention.

In all the experimental set-ups of the results shown magnetic imaging was performed with a commercial SNVM (the Qnami ProteusQ, Qnami AG) operating under ambient conditions.

A commercial diamond tip hosting a single NV$^-$ defect at its apex (Qnami, Quantilever MX) has an integrated quartz tuning fork to allow frequency modulation-based AFM (FM-AFM) and is scanned above an array of nanopillars arranged in a MRAM wafer.

The magnetic field strength indicated in some of the figures is given in the unit Gauss (G). As the skilled person knows, 10'000 G correspond to 1 Tesla (T). The strength of the magnetic fields measured in the depicted scans can therefore easily be converted into the SI unit T.

Figure 1A shows an magnetometry scan of a portion of an MRAM wafer. A first seep to a saturation field ($\mu_0H_{sat}$) was applied to the wafer, which put all the nanomagnets in the "direction down", as indicated in the image for an individual nanopillar. A subsequent sweep to a switching field ($\mu_0H_c$) was then applied to switch a at least some of the nanomagnets into the "direction up", which is also indicated in the image for an individual nanopillar.

Figure 1A depicts an "as-grown" situation, i.e. a situation without magnetic history. Here, about 50% of the nanomagnets have a "down" direction and the remainder have a "up" direction. Examples of nanomagnetic arrays with magnetic history are provided in Figures 5A to 5E.

The detected magnetic field strength of the nanomagnets, which are nanopillars in this case, is indicated in grey scale. Each pillar can easily be localised using the cartesian X and Y axes beside the image. Some of the binary nanomagnets which have switched their magnetic orientation are indicated with an arrow. A schematic presentation of the nanomagnet (1) and the tip of the SNVM sensor probe scanning the surface of the nanomagnet is shown on the left to the scan. The white arrow in the nanomagnet indicates the orientation of its magnetization. The black arrow in the sensor tip indicates the orientation of the NV- centre, which is characterized by its polar angle $\theta_{NV}$ and its azimuthal angle $\varphi_{NV}$.

Nanomagnets with mostly white surfaces have one orientation of magnetization, wherein nanomagnets with mostly black surfaces have the opposite orientation of magnetization.

Figure 1B and 1C illustrate schematically an array of 100 nanomagnets after a first switching cycle (Fig 1B) and after a second switching cycle (Fig 1C).

A switching cycle as referred to herein consists of applying a first saturation magnetic field ($\mu_0H_{sat}$) having a first direction and subsequently applying a second magnetic field ($\mu_0H_c$) having a second direction, which is different to the first direction, to the plurality of nanomagnets.

As can be seen in Figure 1B, 10% of the nanomagnets of the array have switched here polarization during the first switching cycle, which is indicated as a switch from white to black in this Figure. The first percentage ($\alpha$) of nanomagnets which switched orientation in the first switching cycle is therefore 10%.

The same array, respectively portion of array, as applicable, is then subjected to a second switching cycle. Following this second cycle 10% of the nanomagnets have switched their magnetic orientation again, as is shown in Figure 1C. The second percentage ($\alpha_1$) of nanomagnets which switched orientation in the second switching cycle is therefore also 10%.

The nanomagnets shown in black or shown striped in Figure 1C have switched their polarization following the second switching cycle. The nanomagnets indicated in stripes are those who have switched their magnetic orientation twice, once during the first switching cycle and a second time during the second switching cycle. These nanomagnets are the effective double-switchers.

In this example of an array of 100 nanomagnets, 4 effective double switchers were identified. The double-switching percentage ($\beta$) is therefore 4%.

The number nanomagnets exhibiting double switching expected to occur based on thermal activation corresponds to the statistical double-switching percentage ($\beta_{ideal}$). The statistical double-switching percentage ($\beta_{ideal}$) is a calculated theoretical value based on the detected number of switches in each switching cycle. It may be calculated as the second fraction or percentage ($\alpha_1$) applied to the first fraction or percentage ($\alpha$) of switches which have occurred during the first switching cycle.

In this study, this ideal statistical double-switching percentage ($\beta_{ideal}$), was be calculated as

$$\beta_{ideal} = \alpha * \alpha_1$$

The statistical double-switching percentage ($\beta_{ideal}$) in the example shown is therefore 1%. However, the effective percentage ($\beta$) of double switches detected is 4%, 3% more than the thermally expected double-switches. This deviation of switching distribution from the ideal thermally expected double-switching percentage ($\beta_{ideal}$) indicates that the array of nanomagnets has a less than ideal behaviour, which may indicate issues with its quality. The deviation may be attributable to geometrical or physical defects of the array.

Figures 2A and 2B show a sequence of switching cycles and an SNVM scan of a portion of an MRAM wafer comprising an array of nanomagnets obtained after sweeping to the second magnetic field ($\mu_0H_c$) of each cycle. The saturation magnetic field ($\mu_0H_{sat}$) is referred to a "saturate", and the second magnetic field ($\mu_0H_c$) as "switch" in these figures.

The total numbers of nanomagnet assessed is indicated underneath each scan as "Total". the number of switched nanopillars and their percentage ($\alpha$), respectively ($\alpha_1$), is also indicated.

Figure 2A shows a sequence of two switching cycles. A selection of nanomagnets which have switched at least once, and a selection of nanomagnets which have switched in both cycles are indicated with arrows.

I Figure 2B a sequence of three switching cycles and their SNVM scans are shown.

The value for the statistical double-switching percentage ($\beta_{ideal}$) and for the effective double-switching percentage ($\beta$) can easily be determined from these Figures as outlined above. Figures 3A to 3C show different magnifications of SNVM scans of a portion of a MRAM wafer in Full-B mode. The sample magnetic field strength of the sweep performed in this study ranged from 6G or 8G to 20G or 22G, which is a range of 0.6mT or 0.8mT to 20mT or 22mT with corresponding to a range of 0.6mT or 0.8mT to 20mT or 22mT with respect to the bias magnetic field applied along the NV- centre axis in the range of 15G (0.15 mT).

The results were taken on an "as-grown" wafer, i.e. a wafer without any previous magnetic field history. Whereas the overall distribution is entirely statistical (i.e. 50% of nanomagnets point in the same direction), the local distribution of orientations is not entirely random but distinct line-like patterns form. These "lines" are formed by nearest-neighbour nanomagnets. This is indicative of interactions between nearest-neighbouring nanomagnets, which provides relevant information for the MRAM fabrication process.

To determine the switching behaviour of the nanomagnets, a SNVM scan can be performed in a Full-B mode, as mentioned above. In Figure 4A a scan in full-B mode performed over a magnetic field sweep ranging from 1.5mT to 3.5mT was performed in 3h measuring time.

To obtain a quicker characterization of the magnetic device, respectively the plurality of nanomagnets, it is also possible to use SNVM to image iso-magnetic field contours that are resonant to a specific microwave frequency $f_{MW}$, hereinafter referred to as 'dual iso-B' mode.

In the scan shown in Figure 4B a scan in dual iso-B mode was performed on the same portion of MRAM wafer imaged in Figure 4A. The dual iso-B mode image shown in Figure 4B corresponds to the magnetic component of $B_{NV}=2.5$ mT. The grey scale in this figure indicates the fluorescence output signal in kilo counts per second (kc/s). The dual iso-B scan was performed in 20 mins retrieving 169 bits, or nanomagnets, wherein on bit comprised 236 pixels. The speed of the scan averages to 1 bit / 7 seconds. When the number of pixels per bit is reduced to 4, 1 bit / 100 ms can be retrieved. By further optimising the SVNM set-up, optical output detection and count, a further increase the scanning speed of about a factor 100 is possible. A scanning speed of about 1 bit / ms is therefore feasible.

It was observed during studies performed according to this invention, that a certain percentage of the MRAM nanomagnets switched more easily. The assumption can be made that a certain percentage will switch, because switching is probabilistic, i.e. "thermal". The percentage of bits, or nanomagnets, that flip depends on the magnetic history. Which individual bits flip and whether they flip more easily than other bits may depend on critical dimension, defects, nearest neighbour interactions and so on.

This is phenomenon is demonstrated by the images shown in Figures 5A to 5E.

In these images nanomagnets with mostly white surfaces have one orientation of magnetization, wherein nanomagnets with mostly black surfaces have the opposite orientation of magnetization.

The orientation of the nanomagnets is easily distinguishable in Figure 5C, for example. Here, one orientation is characterized by circles that have mostly a white contrast, with a dark-grey shade at the upper half-radius. The other orientation is characterized by circles that are mostly black, with a light-grey contrast at the upper half radius.

Figure 5A shows the as-grown status, where half of the nanomagnets point in one, and the other half in the other direction.

Figure 5B shows an image after a first saturation magnetic field ($\mu_0H_{sat}$) has been applied. Here all nanomagnets point in the same direction.

Figure 5C, Figure 5D and Figure E show results after a saturation magnetic field and a second magnetic field ($\mu_0H_c$) was applied and where now 45%, 14%, or 1% of the nanomagnets point in one direction, as indicated in the respective Figures.

Based on the magnetic history of the plurality of nanomagnets, which are preferably arranged in an array, the likelihood of a switching of nanomagnets in a defined local area may be estimated. To this end, localisation maps may be used to identify which individual nanomagnets switch their orientation in a system or array of nanopillars having a certain magnetic history. The local information on individual nanomagnets can then be used to determine, if for example nearest-neighbour switching, or if switching at the edge of the array is more likely to occur.

It was furthermore observed that the orientation of the NV⁻ spin defect influenced the pattern of the image received for individual binary nanomagnets. This is effect is shown in Figures 6A to 6C, each schematically indicating the polarization of the nanomagnet with a white arrow and the orientation of the NV⁻ centre in the sensor tip with a black arrow. In each of these Figures, the orientation of magnetization of the nanomagnet is the same, i.e. orthogonal to the upper face of the nanopillar, while the polar angle $\theta_{NV}$ of the NV⁻ centre changes. The corresponding SNVM images obtained for each of these set-ups is shown underneath the respective illustration.

In Figure 6A the orientation of the spin is tilted off plane of the measured surface. The upper face of the nanopillar does not appear homogenous but has a bright and a dark portion in this polarization of the nanomagnet. In a switched polarization the imaged dark and fair portions would be inverted.

In Figure 6B the orientation of the spin is on plane in respect of the measured surface. As can be seen in the corresponding SNVM image, about half of the measured face of the nanopillar appears bright, and the other half appears dark. Again, a switching of the binary nanomagnet would result in a flipping of brightness of these halves.

In Figure 6C the orientation of the spin is entirely off plane in respect of the measured surface. The orientation of the spin is parallel to the magnetic orientation of the nanopillar. It is notable, that the SNVM image obtained for this kind of arrangement shows a uniform brightness of the measured surfaces of the nanopillars. In this case, all surfaces appear dark. It was noticed, that when used in this set-up, less pixels are required when the SNVM scan is performed in dual iso-B mode. The speed of the scan can therefore be optimized when performed using this set-up.

Figure 6D depicts a similar setup as shown in Figure 6B, however in this experiment the orientation the magnetization of the nanopillar was tilted with respect to its measured surface by the application of a field perpendicular to the nanopillar. The resulting image showed a more complex pattern of bright and dark zones on the face of the nanopillar. Due to the heterogenous distribution of bright and dark zones on the nanopillars, it is more difficult to ascertain the switching of an individual nanopillar. However, the canted magnetization angle of the nanopillar can be calculated from such maps. The canting behaviour under external field contains valuable information for MRAM characterization.

**Claims**

1. A method for characterizing a magnetic device including a plurality of binary nanomagnets, which may be arranged in an array, comprising

    (i) applying a saturation magnetic field ($\mu_0 H_{sat}$) having a first direction to a plurality of binary nanomagnets to induce a first magnetic orientation in the plurality of nanomagnets,

    (ii) applying a second magnetic field ($\mu_0 H_c$) having a second direction, which is different to the first direction, to the plurality of nanomagnets,

    (iii) repeating steps (i) to (ii),

    (iv) determining a first fraction or percentage ($\alpha$) of nanomagnets which switched orientation in step (ii) and a second fraction or percentage ($\alpha_1$) of nanomagnets which switched orientation in the repeated step (ii),

    (v) determining a statistical double-switching percentage $\beta_{ideal}$ based on the determined first fraction or percentage $\alpha$ and the determined second fraction or percentage $\alpha_1$ of nanomagnets which switched orientation;

    (vi) determining the effective double-switching fraction or percentage ($\beta$) of individual nanomagnets which have switched orientation in step (ii) as well as in the repeated step (ii),

wherein a statement about the quality of the plurality of nanomagnets is made based on the comparison between the determined statistical double-switching percentage ($\beta_{ideal}$) and the determined effective double-switching percentage ($\beta$) of the plurality of nanomagnets.

2. The method according to claim 1, wherein the second direction is the opposite direction of the first direction.

3. The method according claim 1 or 2, further comprising identifying individual nanomagnets which switched orientation in step (ii) and identifying individual nanomagnets which switched orientation in the repeat of step (ii).

4. The method according to claim 3, wherein the identification of an individual nanomagnet is based on said nanomagnet's local information, such as position.

5. The method according to any of claims 1 to 4, comprising the step of determining, based on the magnetic history of the plurality of nanomagnets in combination with the local information of individual nanomagnets, which switched orientation after step (ii), preferably the first step (ii), the likelihood of a switching of nanomagnets with a defined local information in a subsequent repeat of step (ii).

6. The method according to any of claims 1 to 5, wherein the determined quality of the device decreases with the increase of difference between the determined statistical double-switching percentage ($\beta_{ideal}$) and the determined effective double-switching percentage ($\beta$).

7. The method according to any of claims 1 to 6, wherein a scanning or mapping of the plurality of nanopillars is performed following each step (ii) to determine the orientation and the local information of the individual binary nanopillars.

8. The method according to claim 7, wherein the mapping is performed by scanning magnetometry, preferably by scanning nitrogen vacancy magnetometry (SNVM).

9. The method according to any of claims 1 to 8, wherein the method is performed under ambient conditions.

10. The method according to any of claims 1 to 9, wherein in steps (i) and (ii) are repeated more than once.

11. The method according to claim 10, wherein a percentage ($\alpha_n$) of nanomagnets which switched orientation in repeat n of step (ii) is determined, wherein nanomagnets which switched orientation in repeat n of step (ii) are identified, wherein the statistical probability of multiple switching ($\beta_{ideal\ n+1}$) of the nanomagnets, which switched orientation in step (ii) and in all the subsequent repeats n of step (ii) is determined, wherein the effective multiple-switching percentage ($\beta_{n+1}$) is determined cumulatively for all repeats, and wherein a statement about the quality of the plurality of nanomagnets is made based on the comparison between the statistical probability of

multiple switching $\beta_{\text{ideal n+1}}$) and the effective multiple switching percentage ($\beta_{n+1}$) of the plurality of nanomagnets.

12. The method according to any of claims 1 to 11, wherein the method is performed without electrically contacting the nanomagnets.

13. The method according to any of claims 1 to 12, wherein the magnetic device comprises one or more carrier elements on which the plurality of nanomagnets is arranged or in which the plurality of nanomagnets is embedded.

14. The method according to claim 13, wherein storage density of the plurality of nanomagnets ranges from 1 nanomagnets per (200nm * 200nm) to 1 nanomagnet per (100nm * 100nm), or from 1 nanomagnets per (100nm * 100nm) to 1 nanomagnet per (100nm * 100nm).

15. The method according to any of claims 1 to 14, wherein the magnetic device is a binary information storage device, such as used for magnetic random access memory (MRAM) wafer.

Fig. 1A

Fig. 1B

Fig. 1C

Fig. 2A

Fig. 2B

Total: 24*25 = 600
Switched: 38
Switched: 6.3%

Total: 24*25 = 600
Switched: 54
Switched: 9%

Fig. 2C

Fig. 3A

Fig 3B

Fig. 3C

Fig. 4A

Fig. 4B

Fig. 5A

Fig 5B

Fig. 5C

Fig. 5D

Fig. 5E

Fig. 6A

Fig. 6B

## Fig. 6C

## Fig. 6D

Europäisches
Patentamt

European
Patent Office

Office européen
des brevets

# EUROPEAN SEARCH REPORT

Application Number

EP 22 17 9955

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/356497 A1 (HUANG XINKUN [US] ET AL) 18 November 2021 (2021-11-18) * paragraph [0022] – paragraph [0038]; figures 1-2 * | 1-15 | INV. G11C29/00 G01R33/12 |
| A | CUI JIZHAI ET AL: "Nanomagnetic encoding of shape-morphing micromachines", NATURE, NATURE PUBLISHING GROUP UK, LONDON, vol. 575, no. 7781, 1 November 2019 (2019-11-01), pages 164-168, XP036988491, ISSN: 0028-0836, DOI: 10.1038/S41586-019-1713-2 [retrieved on 2019-11-06] * the whole document * | 1-15 | |

TECHNICAL FIELDS
SEARCHED      (IPC)

G11C
G01R

The present search report has been drawn up for all claims

| Place of search | Date of completion of the search | Examiner |
|---|---|---|
| The Hague | 9 November 2022 | Lecoutre, Renaud |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

**EP 22 17 9955**

This annex lists the patent family members relating to the patent documents cited in the above-mentioned European search report.
The members are as contained in the European Patent Office EDP file on
The European Patent Office is in no way liable for these particulars which are merely given for the purpose of information.

**09-11-2022**

| Patent document cited in search report | Publication date | Patent family member(s) | Publication date |
|---|---|---|---|
| US 2021356497 A1 | 18-11-2021 | NONE | |

EPO FORM P0459

For more details about this annex : see Official Journal of the European Patent Office, No. 12/82